Europäisches Patentamt

European Patent Office

Office européen des brevets

(11) Veröffentlichungsnummer: **0 045 469**
**B1**

(12) **EUROPÄISCHE PATENTSCHRIFT**

(45) Veröffentlichungstag der Patentschrift:
**14.05.86**

(21) Anmeldenummer: **81105932.8**

(22) Anmeldetag: **28.07.81**

(51) Int. Cl.⁴: **G 11 C· 17/00, H 01 L 29/60**

(54) **Nichtflüchtige, programmierbare integrierte Halbleiterspeicherzelle.**

(30) Priorität: **04.08.80 DE 3029539**

(43) Veröffentlichungstag der Anmeldung:
**10.02.82 Patentblatt 82/6**

(45) Bekanntmachung des Hinweises auf die Patenterteilung:
**14.05.86 Patentblatt 86/20**

(84) Benannte Vertragsstaaten:
**DE FR GB IT**

(56) Entgegenhaltungen:
**US - A - 4 035 820**

(73) Patentinhaber: **Deutsche ITT Industries GmbH,**
**Hans-Bunte-Strasse 19 Postfach 840, D-7800 Freiburg**
**(DE)**

(84) Benannte Vertragsstaaten: **DE**

(73) Patentinhaber: **ITT INDUSTRIES INC., 320 Park Avenue,**
**New York, NY 10022 (US)**

(84) Benannte Vertragsstaaten: **FR GB IT**

(72) Erfinder: **Adam, Fritz Günter, Dr. rer.nat Dipl.-Phys.,**
**Furtwänglerstrasse 10, D-7800 Freiburg (DE)**

(74) Vertreter: **Morstadt, Volker, Dipl.-Ing., c/o Deutsche ITT**
**Industries GmbH Patent/Lizenzabteilung**
**Postfach 840 Hans-Bunte-Strasse 19,**
**D-7800 Freiburg/Brsg. (DE)**

## Beschreibung

Aus der Zeitschrift «IEEE Transactions on Electron Devices» Band ED-24, Nr. 5 (Mai 1977), Seiten 594 bis 599, ist eine nichtflüchtige, programmierbare integrierte Halbleiterspeicherzelle bekannt, welche einen Lese-FET mit einer bei normaler Betriebsspannung potentialmässig schwebenden Gate-Elektrode enthält. Bei dieser bekannten Halbleiterspeicherzelle erstreckt sich die Gate-Elektrode in ihrer Flächenausdehnung über die Gate-Fläche des Lese-IGFETs hinaus und ist über zwei Flächenteile von Isolierschichtteilen in einer Dikke, welche das Überspringen von heissen Ladungsträgern erlaubt, kapazitiv an zwei Programmierelektroden – nämlich eine Schreibelektrode und eine Löschelektrode – in Form von planaren Zonen des einen Leitungstyps in einem halbleitenden Substrat vom anderen Leitungstyp angekoppelt. Die Programmierelektroden bilden $P^+N$- bzw. $N^+P$-Übergänge, wobei der $P^+N$-Übergang heisse Löcher und der $N^+P$-Übergang heisse Elektronen in die angrenzenden Isolierschichtteile der Gate-Isolatorschicht injiziert, sobald die Durchbruchspannung eines der Übergänge überschritten wird und ein Avalanche-Durchbruch eingeleitet ist. Bei geeignet dünn bemessenen, an die Programmierelektroden angrenzenden Isolierschichtteilen durchtunnelt ein kleiner Bruchteil der heissen Ladungsträger die Isolierschichtteile und lädt bzw. entlädt die potentialmässig schwebende Gate-Elektrode. Die von den heissen Ladungsträgern zu durchtunnelnden Isolierschichtteile der Gate-Isolatorschicht sind bei der bekannten Speicherzelle auf ein schmales Band angrenzend an die Durchstosslinie des $P^+N$- bzw. $N^+P$-Übergangs durch die Grenzfläche Halbleitersubstrat-Gate-Isolatorschicht beschränkt. Die betroffenen Isolierschichtteile der Gate-Isolatorschicht werden daher relativ schnell beschädigt, so dass nur eine stark begrenzte Anzahl von Programmierzyklen ohne wesentliche Schädigungen möglich ist.

Der Erfindung liegt die Aufgabe zugrunde, die bei der bekannten Halbleiterspeicherzelle stark begrenzte Anzahl an Programmierzyklen zu erhöhen. Diese Anzahl ist bekanntlich dadurch begrenzt, dass die Differenz zwischen einer oberen Schwellenspannung und einer unteren Schwellenspannung, was als Schwellenspannungsfenster bezeichnet wird, mit zunehmender Anzahl der Programmierzyklen immer kleiner wird.

Die Erfindung geht von dem Gedanken aus, dass dieser nachteilige Effekt auf einer Schädigung des Gate-Isolators beruht und dass die Durchtrittsfläche der heissen Ladungsträger zu vergrössern ist, um die Belastung der Gate-Isolatorschicht auf eine grössere Fläche zu verteilen.

Die Erfindung betrifft somit die bekannte Halbleiterspeicherzelle gemäss dem Oberbegriff des Anspruchs 1.

Die oben genannte Aufgabe wird erfindungsgemäss durch die im kennzeichnenden Teil des Anspruchs 1 angegebene Ausbildung gelöst.

Des weiteren sind in den Unteransprüchen Weiterbildungen angegeben, welche insbesondere flächensparende Weiterbildungen der Halbleiterspeicherzelle nach der Erfindung betreffen. So kann beispielsweise entweder die planare Schreibelektrode oder die planare Löschelektrode mit der Source-Zone oder mit der Drain-Zone als zusammenhängende Zone ausgebildet werden.

Der seitliche Abstand zwischen der Schreibelektrode und dem Diffusionsbereich sollte im übrigen grundsätzlich zur Absaugung der Ladungsträger im Substrat, welche beim Avalanche-Durchbruch erzeugt werden und nicht die Gate-Isolatorschicht durchtunneln, etwas kleiner sein als die Breite der Feldzone, die sich im Substrat ausbildet, wenn an die Schreibelektrode die Schreibspannung angelegt wird.

Die Koppelkapazität, die die Schreibelektrode über den angrenzenden Isolierschichtteil mit der Gate-Elektrode bildet sollte mindestens achtmal grösser sein als die Koppelkapazität, die von der Löschelektrode über den angrenzenden Isolierschichtteil mit der Gate-Elektrode gebildet wird.

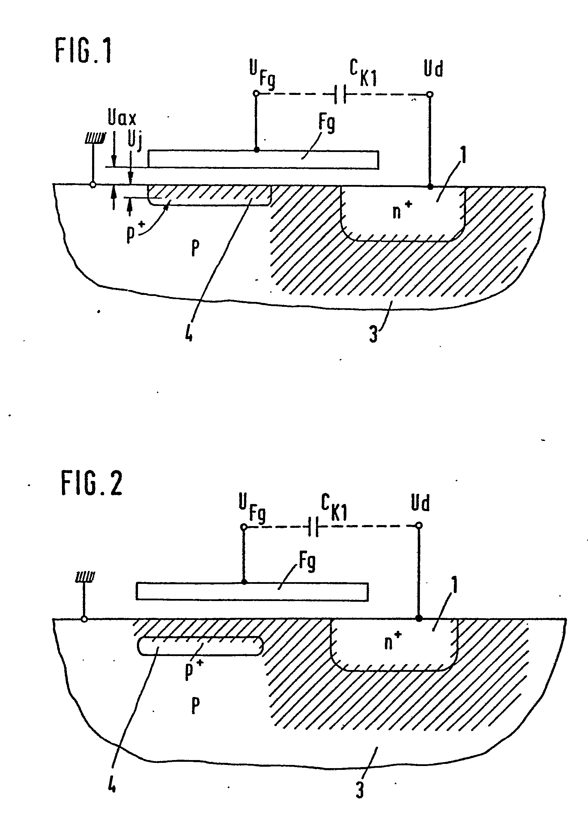

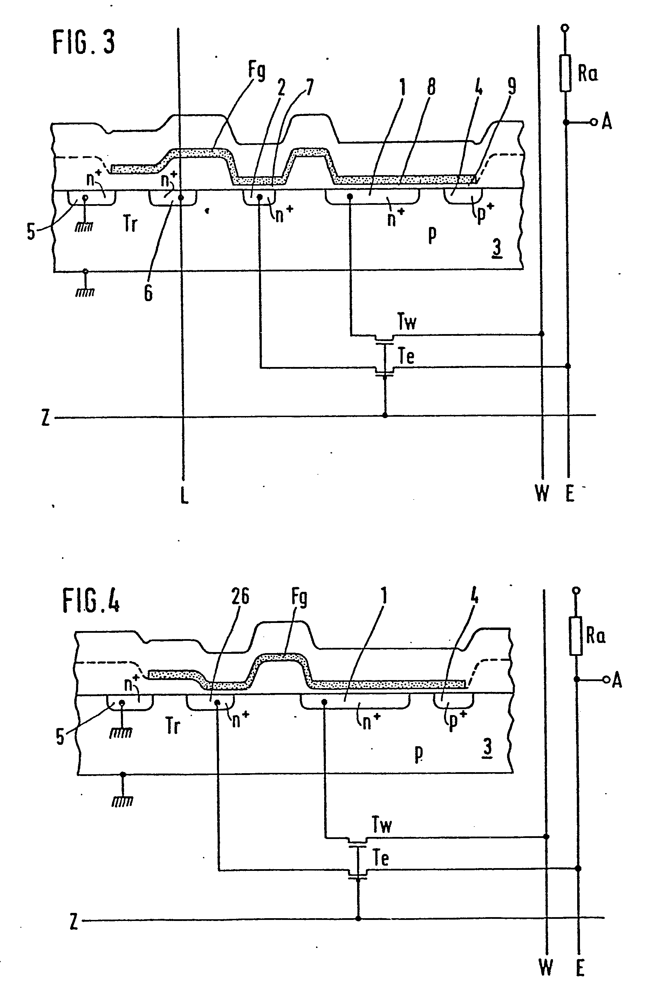

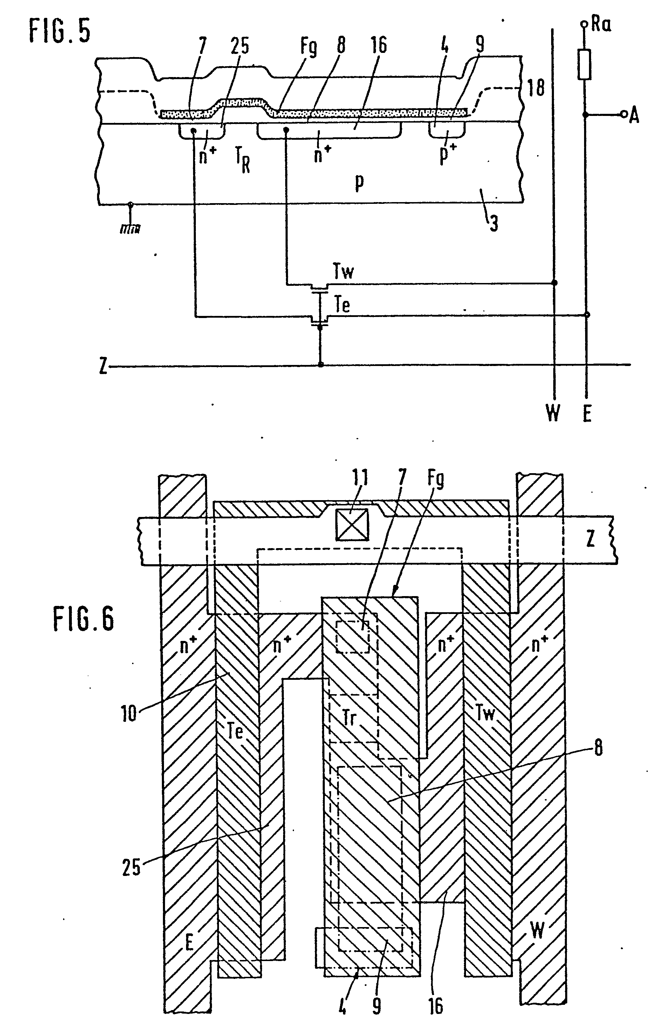

Die Halbleiterspeicherzellen nach der Erfindung, deren Wirkungsweise, deren Betriebsweise und deren Ausführungsbeispiele werden im folgenden anhand der Zeichnungen erläutert,

deren Fig. 1 und 2 zur Erläuterung der Wirkungsweise der als Minoritäten-Injektoren wirksamen Diffusionsbereiche dienen,

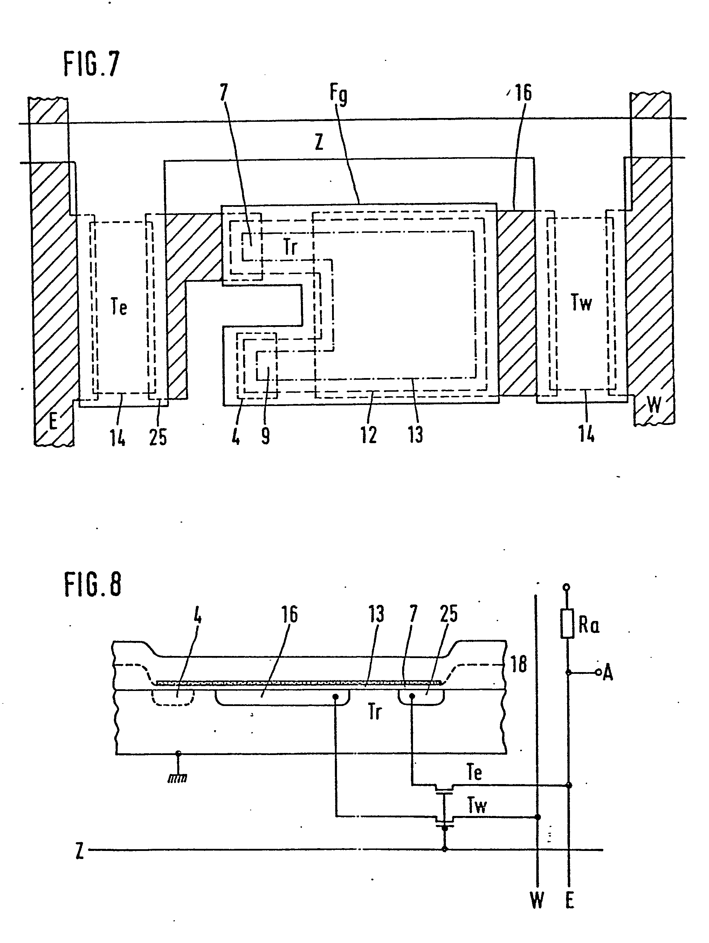

deren Fig. 3 und 4 schematisch ein erstes und ein zweites Ausführungsbeispiel mit je einer Querschnittsteilansicht senkrecht zu einem plattenförmigen Substrat veranschaulichen,

deren Fig. 5 schematisch in gleicher Querschnittsansicht ein drittes platzsparendes Ausführungsbeispiel zeigt,

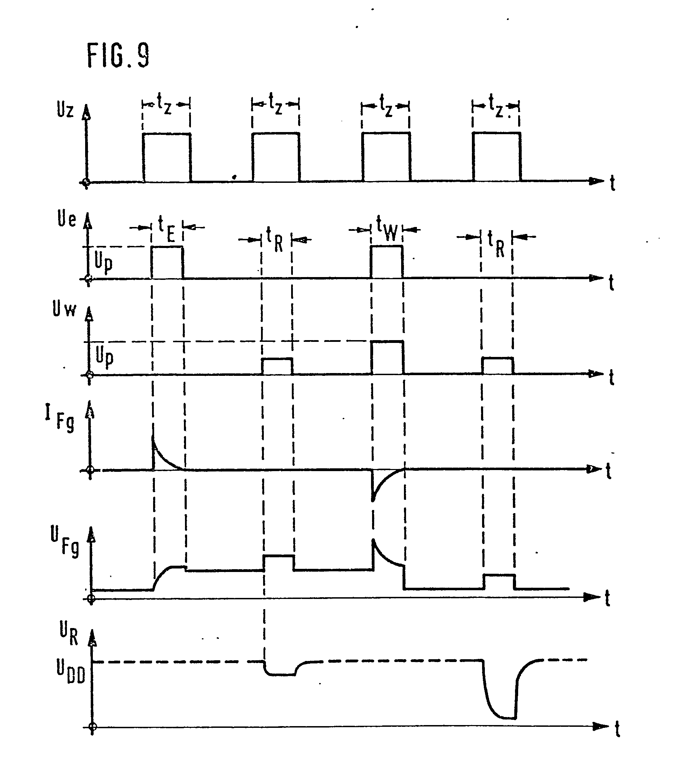

deren Fig. 6 eine Topologie der Speicherzelle der Fig. 5 in Si-Gate-Ausführung in Aufsicht auf das plattenförmige Substrat veranschaulicht,

deren Fig. 7 eine Topologie der Speicherzelle der Fig. 5 in Al-Gate-Ausführung in gleicher Aufsicht zeigt,

deren Fig. 8 eine als Weiterbildung der Speicherzelle nach der Fig. 5 aufzufassendes Ausführungsbeispiel betrifft und

deren Fig. 9 die Pulsfolgen beim Programmieren und Lesen der Speicherzelle nach der Fig. 5 oder der Fig. 8 veranschaulicht.

Zur Erläuterung der Wirkungsweise eines im Substrat eingesetzten Diffusionsbereiches als flächenhafter Minoritäten-Injektor in einer Halbleiterspeicherzelle nach der Erfindung wird zunächst auf die Fig. 1 eingegangen, welche ausschnittsweise die Querschnittsansicht durch die potentialmässig schwebende Gate-Elektrode Fg, die als planare Zone im Substrat 3 realisierte Schreibelektrode 1 und durch den planar ausgebildeten Diffusionsbereich 4 zeigt. Die schraffiert dargestellte Feldzone des pn-Übergangs der Schreibelektrode 1 erreicht die Diffusionszone 4 und überlappt diese um ein kleines Stück.

Zur Berechnung der Spannung Uj, welche für den Avalanche-Durchbruch an der Halbleiteroberfläche massgeblich ist, wird das Substrat 3 auf Masse gelegt. Mit der Spannung $U_{Fg}$ der Gate-Elektrode und der Spannung Ud an der Schreibelektrode 1 erhält man mit

$$Uj = U_{Fg} \frac{Cox}{Cox + Cj} \quad und \quad Cj = \frac{\varepsilon_s \cdot q \cdot N}{2\,Uj}$$

unter Verwendung der Abkürzung Cox für die Oxidkapazität, Cj für die an Uj anliegende Kapazität, $\varepsilon_s$ für die Dielektrizitätskonstante des Siliciums, q für die Elementarladung und N für die Dotierungskonzentration des p-dotierten Diffusionsbereichs 4 an der Oberfläche die Gleichung

$$Uj = U_{Fg} + \frac{\varepsilon_s \cdot q \cdot N}{Cox^2} - \sqrt{\left(U_{Fg} + \frac{\varepsilon_s \cdot q \cdot N}{Cox^2}\right)^2 - U_{Fg}2}$$

Unter Verwendung der vorstehenden Gleichung durchgeführte Berechnungen und Versuche ergaben, dass brauchbare Programmierspannungen im Bereich zwischen 20 V und 35 V erhalten werden, wenn die Netto-Dotierungskonzentration die Beziehung

$$\frac{N}{cm^{-3}} \geqslant 2{,}6 \cdot 10^{17} \cdot \left(\frac{Up}{20\,V}\right)^{-\frac{1}{2}}$$

und die Dicke Xox des Dielektrikums aus thermisch auf einem Si-Substrat aufgewachsenen Siliciumoxid der beiden Koppelkapazitäten zwischen der Schreib- bzw. der Löschelektrode einerseits und der Gate-Elektrode Fg andererseits die Beziehung

$$\frac{Xox}{\text{Å}} = 665 \cdot \left(\frac{Up/V}{N/10^{16}\,cm^{-3}}\right)^{\frac{1}{2}} \pm 5\,\%$$

erfüllen, wobei Vp die an die Schreibelektrode anzulegende Programmierspannung bedeutet.

Dabei sollte der die Koppelkapazität $C_{K1}$ der Schreibelektrode 1 zur Gate-Elektrode Fg bildende Flächenteil mindestens achtmal grösser bemessen werden als der die Koppelkapazität der Löschelektrode 2 bildende Flächenteil der Gate-Isolatorschicht zur Gate-Elektrode Fg.

Die Diffusionstiefe des Diffusionsbereichs 4 nach der Ausführungsform der Fig. 1 kann etwa 1 µm betragen. Der Diffusionsbereich 4 kann aber auch, wie die Fig. 2 veranschaulicht, im Bereich von Bruchteilen von 1 µm unter die Halbleiteroberfläche gelegt werden. Dabei ist darauf zu achten, dass die Feldzone den Raum zwischen der Halbleiteroberfläche und dem Diffusionsbereich 4 ausfüllt. Ein unter die Halbleiteroberfläche gelegter Diffusionsbereich 4 gemäss der Fig. 2 kann durch Ionenimplantation oder subepitaxiale Diffusion hergestellt werden.

Grundsätzlich erfolgt das Programmieren der Halbleiterspeicherzelle nach der Erfindung dadurch, dass die Programmierspannung beim Schreiben an die über die grössere Kapazität $C_{K1}$ angekoppelte Schreibelektrode 1 und beim Löschen an die über die kleinere Kapazität angekoppelte Löschelektrode 2 kurzzeitig angelegt wird, während die jeweils andere Programmierelektrode an das Potential des Substrats 3 gelegt ist. Beim Schreiben kann jedoch zusätzlich die gleiche Programmierspannung Up ausser an die Schreibelektrode auch noch an die Löschelektrode angelegt werden. Das Vorzeichen der Programmierspannung Up richtet sich natürlich nach dem Leitungstyp des Lese-IGFET's. Die Programmierspannung Up ist bei einer n-Kanal-Speicherzelle nach der Erfindung vom positiven Vorzeichen und bei einer P-Kanal-Speicherzelle nach der Erfindung von negativem Vorzeichen in bezug auf das Substrat 3 zu wählen.

Beim Lesen einer Halbleiterzelle nach der Erfindung wird an die Schreibelektrode 1 eine Spannung angelegt, die wesentlich kleiner ist als die Programmierspannung Up und kleiner als die beim Schreiben erzeugte relativ hohe Schwellenspannung des Lese-IGFET's Tr. Der Lese-IGFET Tr kann beim Lesen als Sourcefolger geschaltet werden. Ein Ausführungsbeispiel einer Speicherzelle nach der Erfindung mit einer besonderen Leseleitung L zeigt die Fig. 3 in Querschnittsansicht. Bei dieser Ausführungsform sind die Schreibelektrode 1 und die Löschelektrode 2 getrennt von der Source-Zone 5 und der Drain-Zone 6 des Lese-IGFET's Tr in die eine Oberflächenseite des plattenförmigen Substrats 3 eindiffundiert worden. Die Isolierschichtteile 7 und 9 über der Löschelektrode 2 bzw. dem Diffusionsbereich 4 sind so dünn zu bemessen, wie im Text zu den Fig. 1 und 2 ausgeführt, so dass das Überspringen von heissen Ladungsträgern möglich ist. Der Isolierschichtteil 8 über der Schreibelektrode erhält vorzugsweise die gleiche Dicke.

Da die Halbleiterspeicherzelle nach der Erfindung zur Verwendung in einer Speichermatrix vorgesehen ist, sind (spaltenweise) Schreibleitungen W und Löschleitungen E vorgesehen. Während die Schreibelektrode 1 über die Source-Drain-Strecke des Schreibtransistors Tw anregbar ist, kann die Löschelektrode über den Löschtransistor Te mit der Löschleitung E verbunden werden, sobald die Wortleitung Z auf ein geeignetes Potential gelegt wird. Dadurch wird das bitweise Programmieren der Speichermatrix möglich. In Weiterbildung der Speichermatrix nach der Fig. 3 werden zur Platzersparnis die Löschelektrode 2 und die Drain-Zone 6 des Lese-IGFET's Tr zu einer gemeinsamen Zone 26 vereinigt, wie die Fig. 4 ohne weiteres erkennen lässt.

In konsequenter Weiterführung des Gedankens der Vereinigung von Zonen zur Platzersparnis, welche bei der Auslegung von Speichermatrizen äusserst wichtig ist, werden sowohl die planare Schreibelektrode 1 als auch die planare Löschelektrode 2 je mit einer der Zonen des Lese-IGFETs Tr vereinigt, wie die weiteren Ausführungsbeispiele der Fig. 5 bis 8 zeigen. Bei diesen Ausführungsbeispielen sind, wie die Fig. 5 und 8 zeigen, die Source-Zone mit der planaren Löschelektrode 2 zu der zusammenhängenden Zone 25 und die planare Schreibelektrode mit der Drain-Zone zu einer zusammenhängenden Zone 16 zusammengefasst worden. Die gestrichelte Linie 18 deutet an, dass nach dem Herstellen der Gate-Elektrode Fg die gesamte Anordnung mit einer darüber abgelagerten Schutzschicht bedeckt worden ist.

Die Fig. 6 zeigt in Aufsicht auf das plattenförmige Substrat, wie die Speicherzelle nach der Fig. 5 in der bekannten Si-Gate-Technologie topologisch realisiert werden kann. Die nicht von Leitbahnen oder Elektroden bedeckten Teile der N$^+$-Diffusion, bei der unter anderem die Schreibleitung W und die Löschleitung E in Form von n$^+$-dotierten Zonenstreifen realisiert wurden, sind gleichsinnig in einer Richtung schraffiert. Diese werden unter Verwendung von Teilen einer U-förmig ausgebildeten Schicht aus polykristallinem Silicium als Diffusionsmaske entsprechend der erwähnten Technologie diffundiert, wobei abgesehen von den erwähnten Leitungen E und W die weiteren Zonen des Löschtransistors Te und des Schreibtransistors Tw diffundiert werden.

Vor dieser Diffusion werden die unter der Gate-Elektrode liegenden n$^+$-dotierten Zonenteile und der p$^+$-dotierte Diffusionsbereich 4 in getrennten Diffusionsprozessen hergestellt. Dann können nämlich der U-förmig ausgebildete Teil und das Silicium der Gate-Elektrode Fg zunächst als eine Schicht in einem Prozessschritt aufgebracht werden. Die nach einer Ätzung verbleibenden Teile dieser Polysiliciumschicht sind – soweit sie von der Wortleitung Z nicht bedeckt sind – in einer anderen Richtung als die n$^+$-dotierte Zone schraffiert. Die Fig. 6 zeigt ferner gestrichelt umrandet die dünnen Isolierschichtteile 7 und 8 über den Zonen 16 und 25.

Senkrecht zu den diffundierten Leitungen E und W verläuft die Wortleitung Z aus auf einer Isolierschicht aufgedampftem Aluminium. Die Isolierschicht erhält eine Kontaktierungsöffnung 11, in der die Wortleitung Z das darunter liegende Polysilicium kontaktiert.

Fig. 7 zeigt als weiteres Ausführungsbeispiel die topologische Auslegung einer Halbleiterspeicherzelle gemäss der Fig. 5 in Al-Gate-Technologie. Dabei werden die Zonen, deren von Elektroden bzw. Leitbahnen nicht bedeckte Teile in der Fig. 7 schraffiert sind, sowie der Diffusionsbereich 4 vor dem Aufdampfen des Aluminiums in den Halbleiterkörper diffundiert. Die gestrichelten Linien 13 und 14 sind die Umrandungslinien der Isolierschichtteile bzw. der Gate-Oxidschichten der Transistoren Te und Tw. Das Aluminium der Wortleitung Z, der Gate-Elektroden der beiden Transistoren Te und Tw wird gleichzeitig mit dem Material der Gate-Elektrode Fg aufgebracht und anschliessend daraus die unter Anwendung eines photolithographischen Ätzprozesses nach der Fig. 7 abgegrenzten Bereiche der Wortleitung Z mit den damit in Verbindung stehenden Gate-Elektroden der beiden Transistoren Te und Tw sowie die Gate-Elektrode Fg herausgeätzt.

Bei dieser Gelegenheit ist zu bemerken, dass das Material der Gate-Elektrode Fg hinsichtlich der Funktionsweise der Speicherzelle nach der Erfindung keine Rolle spielt, da die Injektion der Elektronen und Löcher beim Laden bzw. Entladen der Gate-Elektrode Fg aus dem Halbleitermaterial von unten erfolgt. Hinsichtlich der Wahl der Technologien besteht also weitgehend keine Beschränkung; die Gate-Elektrode Fg kann aus einem Metall oder aus einem dotierten Halbleitermaterial in gleicher Weise hergestellt werden.

In Weiterbildung der Ausbildungsform der Fig. 5 weisen die Isolierschichtteile über den Zonen 16 und 25 die gleiche Dicke auf wie die des Lese-IGFETs Tr, wie die Fig. 8 ohne weiteres erkennen lässt. Diese Ausführungsform hat gegenüber der der Fig. 5 den Vorteil einer erleichterten Herstellbarkeit.

Beim Lesen einer in einer Halbleitermatrix angeordneten Speicherzelle nach der Erfindung wird die zugehörige Wortleitung Z auf eine Spannung gleich der oder kleiner als die Programmierspannung gelegt.

Bei einer Halbleiterspeicherzelle gemäss der Fig. 3 werden zu diesem Zweck die beiden zugehörigen Bitleitungen, nämlich Schreibleitung W und Löschleitung E, auf ein gemeinsames Lesepotential gebracht, welches maximal etwa halb so gross ist wie die Programmierspannung. Gleichzeitig werden alle übrigen Wort- und Bitleitungen auf Substratpotential gelegt.

Zum Lesen einer Halbleiterspeicherzelle gemäss der Fig. 4, 5 oder 8, d. h. einer Halbleiterspeicherzelle, bei der die Source- und/oder die Drain-Zone des Lese-IGFETs Tr mit der planaren Schreibelektrode bzw. mit der planaren Löschelektrode als zusammenhängende Zonen ausgebildet sind, wird lediglich die Schreibleitung W auf ein Lesepotential gebracht, welches maximal etwa halb so gross ist wie die Programmierspannung, während die Löschleitung über ein Widerstandselement Ra, beispielsweise ein hochohmiger, aufgesteuerter Transistor, an Substratpotential wie die Wort- und Bitleitungen der übrigen nicht zu lesenden Speicherzellen liegt. Die gespeicherte Information wird am Widerstandselement Ra bei A abgegriffen, so dass der Löschtransistor Te als Sourcefolger arbeitet.

Die Fig. 9 veranschaulicht die Pulsfolgen der Spannungen auf der Wortleitung Z, der Löschleitung E, der Schreibleitung W, der Gate-Elektrode Fg gegen das Massepotential und die über den Lesetransistor Tr abfallende Spannung U$_R$ im Verlauf eines Zyklus Löschen-Lesen-Schreiben-Lesen. Diese Funktionen müssen natürlich innerhalb von Intervallen t$_z$ durchgeführt werden, in denen der Schreibtransistor Tw und der Löschtransistor Te leitend getastet werden, indem an die Wortleitung Z eine Spannung Uz angelegt wird. Während des ersten Funktionsintervalls «Löschen» wird an die Löschleitung E ein Impuls Up der Breite t$_E$ angelegt, wie aus der zweiten Zeile der Fig. 9 entnehmbar ist, in der die Spannung Ue über die Zeit aufgetragen ist. Gleichzeitig liegt die Spannung Uw der Schreibelektrode auf Null. Aus der Gate-Elektrode Fg werden Ladungsträger gezogen, wobei kurzzeitig ein abnehmender Ladungsträgerstrom gezogen wird, wie aus der vierten Zeile der Fig. 9 ersichtlich ist, in der die zeitliche Abhängigkeit der Ladungs- bzw. Entladungsströme der Gate-Elektrode Fg aufgetragen sind. Dementsprechend ändert sich das Potential der Gate-Elektrode Fg, wie aus der fünften Zeile der Fig. 9 ersichtlich ist.

Während des anschliessenden Funktionsintervalls «Lesen» wird an die Schreibleitung W ein Impuls wesentlich kleiner als Up angelegt, wie aus der dritten Zeile der Fig. 9 ersichtlich ist, in der die zeitliche Abhängigkeit der Spannung Uw auf der Schreibleitung aufgetragen ist. An dem Lesetransistor Tr kann während dieses Intervalls $t_R$ die in der letzten Zeile der Fig. 9 angegebene Spannung abgegriffen werden.

Während des darauffolgenden Funktionsintervalls «Schreiben» werden an die Löschleitung E und an die Schreibleitung W die aus der zweiten und dritten Zeile der Fig. 9 ersichtlichen Up-Impulse der Dauer $t_w$ angelegt, so dass in die Gate-Elektrode Fg der Ladestrom gemäss der vierten Zeile der Fig. 9 injiziert wird und dementsprechend eine Änderung der Spannung $U_{Fg}$ erhalten wird.

Im vierten Funktionsintervall «Lesen», bei dem der nunmehr gesperrte Lesetransistor Tr abgetastet wird, ergibt sich der Spannungsverlauf $U_R$, wie er in der letzten Zeile der Fig. 9 angegeben ist.

## Patentansprüche

1. Nichtflüchtige programmierbare integrierte Halbleiterspeicherzelle, enthaltend einen Lese-IGFET (Tr) mit einer bei normaler Betriebsspannung potentialmässig schwebenden Gate-Elektrode (Fg), welche sich in ihrer Flächenausdehnung mit Elektrodenteilen über die Gate-Fläche des Lese-IGFETs (Tr) hinaus erstreckt und über zwei Flächenteile an Isolierschichtteilen (8, 7) in einer Dicke, welche das Überspringen von heissen Ladungsträgern erlaubt, kapazitiv an zwei Programmierelektroden – nämlich eine Schreibelektrode (1) und eine Löschelektrode (2) – in Form von planaren Zonen vom ersten Leitungstyp in einem halbleitenden Substrat (3) vom zweiten Leitungstyp angekoppelt sind, dadurch gekennzeichnet,
– dass der Flächenteil der Gate-Elektrode (Fg) an der Schreibelektrode (1) grösser ist als der Flächenteil an der Löschelektrode (2),
– dass neben der Schreibelektrode (1) im geringen Abstand davon an der Oberfläche des Substrats (3) unter der Gate-Elektrode (Fg) ein Diffusionsbereich (4) kleinerer Flächenausdehnung als die Flächenausdehnung der Schreibelektrode (1) und vom gleichen Leitungstyp wie das Substrat (3) angeordnet ist,
– dass die Umladung der schwebenden Gate-Elektrode (Fg) durch Minoritäteninjektion erfolgt, die beim Schreiben durch den Flächenteil des Diffusionsbereichs (4) an der Gate-Elektrode (Fg) in Gestalt eines Stromes heisser Minoritäten des Substrats (3) und beim Löschen durch den Flächenteil der Löschelektrode (2) erfolgt und
– dass die Gate-Elektrode (Fg) mindestens einen Teil des der Schreibelektrode (1) nächstliegenden Randes des Diffusionsbereichs (4) überlappt.

2. Halbleiterspeicherzelle nach Anspruch 1, dadurch gekennzeichnet, dass der seitliche Abstand zwischen der Schreibelektrode (1) und dem Diffusionsbereich (4) etwas kleiner ist als die Breite der Feldzone, die sich im Substrat (3) ausbildet, wenn an die Schreibelektrode (1) die Schreibspannung (Uw) angelegt wird.

3. Halbleiterspeicherzelle nach Anspruch 1 oder 2, dadurch gekennzeichnet, dass entweder die planare Schreibelektrode (1) oder die planare Löschelektrode (2) mit der Source-Zone (5) des Lese-IGFETs (Tr) als zusammenhängende Zone (25) ausgebildet ist.

4. Halbleiterspeicher nach Anspruch 1 oder 2, dadurch gekennzeichnet, dass entweder die planare Schreibelektrode (1) oder die planare Löschelektrode (2) mit der Drain-Zone (6) des Lese-IGFETs (Tr) als zusammenhängende Zone (16, 26) ausgebildet ist (Fig. 4).

5. Halbleiterspeicherzelle nach einem der Ansprüche 1 bis 4, dadurch gekennzeichnet, dass die planare Schreibelektrode (1) mit der Drain-Zone (6) des Lese-IGFETs (Tr) und die planare Löschelektrode (2) mit der Source-Zone (5) des Lese-IGFETs (Tr) zu je einer zusammenhängenden Zone (16, 25) ausgebildet sind (Fig. 5).

6. Halbleiterspeicherzelle nach einem der Ansprüche 1 bis 5, dadurch gekennzeichnet, dass die Programmierspannung Up, dass die Netto-Dotierungskonzentration N mindestens eines Teilgebietes des Diffusionsbereichs (4), dessen Randlinie von dem die Koppelkapazität bildenden Flächenteil der Gate-Elektrode (Fg) überragt wird, und dass die Dicke Xox des Dielektrikums der beiden Koppelkapazitäten nach folgenden Beziehungen gewählt werden:

$$20\,V \leq Up \leq 35\,V$$

$$\frac{N}{cm^{-3}} \geq 2{,}6 \cdot 10^{17} \left(\frac{Up}{20\,V}\right)^{-\frac{1}{2}}$$

$$\frac{Xox}{\text{Å}} = 665 \cdot \left(\frac{Up/V}{N/10^{16}\,cm^{-3}}\right)^{\frac{1}{2}} \pm 5\,\%$$

7. Halbleiterspeicherzelle nach einem der Ansprüche 1 bis 6, dadurch gekennzeichnet, dass der die Koppelkapazität der Schreibelektrode (1) bildende Flächenteil der Gate-Elektrode (Fg) mindestens achtmal grösser ist als der die Koppelkapazität der Löschelektrode (2) bildende Flächenteil der Gate-Elektrode (Fg).

8. Halbleiterspeicherzelle nach einem der Ansprüche 1 bis 7, dadurch gekennzeichnet, dass die Gate-Elektrode (Fg) aus einem Metall besteht.

## Claims

1. Nonvolatile, programmable integrated semiconductor memory cell containing a reading IGFET (Tr) with a floating gate electrode (Fg) at normal supply voltage, which in its surface extension stretches with electrode parts beyond the gate surface of the reading IGFET (Tr) and, via two surface portions, is coupled to insulated-gate portions (8, 7) in a thickness permitting the junction crossing of hot carriers, capacitively to two programming electrodes – namely one writing electrode (1) and one erasing electrode (2) – in the form of planar regions of a first conductivity type in a semiconducting substrate (3) of a second conductivity type, characterized in

- that the surface portion of said gate electrode (Fg) on said writing electrode (1) is larger than the surface portion on said erasing electrode (2),
- that next to said writing electrode (1), at a small distance therefrom, on the surface of said substrate (3) below said gate electrode (Fg) there is arranged a diffusion region (4) of smaller surface dimension than that of said writing electrode (1), and of the same conductivity type as said substrate (3),
- that the recharging of said floating gate electrode (Fg) is effected by way of minority injection which, during the writing operation, is effected through the surface portion of said diffusion region (4) on said gate electrode (Fg) in the form of a current of hot minority carriers of said substrate (3) and, during the erase operation, through the surface portion of said erasing electrode (2), and
- that said gate electrode (Fg) overlaps at least one portion of the edge of said diffusion region (4) lying nearest to said writing electrode (1).

2. A semiconductor memory cell as claimed in claim 1, characterized in that the lateral spacing between said writing electrode (1) and said diffusion region (4) is somewhat smaller than the width of the field zone which is formed in said substrate (3) when the writing voltage (Uw) is applied to said writing electrode (1).

3. A semiconductor memory cell as claimed in claims 1 or 2, characterized in that either said planar writing electrode (1) or said planar erasing electrode (2) is designed to form a continuous zone (25) together with the source region (5) of said reading IGFET (Tr).

4. A semiconductor memory cell as claimed in claim 1 or 2, characterized in that either said planar writing electrode (1) or said planar erasing electrode (2) is designed to form a continuous zone (16, 26) together with the drain region (6) of said reading IGFET (Tr) (Fig. 4).

5. A semiconductor memory cell as claimed in any one of claims 1 to 4, characterized in that said planar writing electrode (1) with said drain region (6) of said reading IGFET (Tr), and said planar erasing electrode (2) with said source region (5) of said reading IGFET (Tr) are each designed to form a continuous zone (16, 25) (Fig. 5).

6. A semiconductor memory cell as claimed in any one of claims 1 to 5, characterized in that the programming voltage (Up), that the net doping concentration N of at least one partial area of the diffusion area (4) whose marginal line is overlapped by the surface portion of said gate electrode (Fg) forming the coupling capacitance, and the thickness Xox of the dielectric of the two coupling capacitances are chosen in accordance with the following relationships:

$$20 \text{ V} \le \text{Up} \le 35 \text{ V}$$

$$\frac{N}{\text{cm}^{-3}} \ge 2{,}6 \cdot 10^{17} \left(\frac{\text{Up}}{20 \text{ V}}\right)^{-\frac{1}{2}}$$

$$\frac{\text{Xox}}{\text{Å}} = 665 \cdot \left(\frac{\text{Up/V}}{\text{N}/10^{16} \text{ cm}^{-3}}\right)^{\frac{1}{2}} \pm 5 \%$$

7. A semiconductor memory cell as claimed in any one of claims 1 to 6, characterized in that said surface portion of said gate electrode (Fg) forming the coupling capacitance of said writing electrode (1), is at least eight times greater than the surface portion of said gate electrode (Fg) forming the coupling capacitance of said erasing electrode (2).

8. A semiconductor memory cell as claimed in any one of claims 1 to 7, characterized in that said gate electrode (Fg) consists of a metal.

**Revendications**

1. Cellule de mémoire à semi-conducteur intégrée programmable non-volatile, comportant un transistor de lecture (Tr) à effet de champ à grille isolée -IGFET dont l'électrode de grille (Fg) est à potentiel flottant en tension normale de fonctionnement, et dont la surface comprend des parties d'électrode s'étendant au-delà de la surface de grille de l'IGFET de lecture (Tr) et est, en deux portions de surface (7, 8) et via une couche isolante d'une épaisseur telle qu'elle est franchissable par des porteurs de charges chauds, couplée capacitivement à deux électrodes de programmation – une électrode d'écriture (1) et une électrode d'effacement (2) – réalisées sous la forme de zones planaires d'un premier type de conductibilité dans un substrat semi-conducteur (3) d'un deuxième type de conductibilité, caractérisée en ce que:

- la portion de surface de l'électrode de grille (Fg) en regard de l'électrode de lecture (1) est plus grande que la portion de surface en regard de l'électrode d'effacement (2),
- une zone de diffusion (4), d'une surface plus petite que la surface de l'électrode d'écriture (1) et du même type de conductibilité que celle du substrat, est disposée à la face supérieure du substrat (3), à côté de l'électrode de lecture (1) à faible distance de celle-ci,
- l'inversion de charge de l'électrode de grille flottante (Fg) est réalisée par injection de porteurs minoritaires, qui lors de l'écriture est effectuée à travers de la portion de surface de la zone de diffusion (4) en regard de l'électrode grille (Fg) sous forme d'un courant de porteurs minoritaires chauds du substrat (3) et qui, lors de l'effacement, est effectuée à travers la portion de surface en regard de l'électrode d'effacement (2), et

– en ce que l'électrode de grille (Fg) recouvre au moins une partie du bord de la zone de diffusion (4) la plus proche de l'électrode de lecture (1).

2. Cellule de mémoire à semi-conducteur selon la revendication 1, caractérisée en ce que la distance latérale entre l'électrode de lecture (1) et la zone de diffusion (4) est légèrement plus petite que la largeur de la zone de champ, qui se forme dans le substrat (3), lorsque la tension d'écriture (Uw) est appliqué à l'électrode d'écriture (1).

3. Cellule de mémoire à semi-conducteur selon la revendication 1 ou 2, caractérisé en ce que, soit l'électrode d'écriture planaire (1), soit l'électrode d'effacement planaire (2), forme une zone continue (25) avec la zone de source (5) de l'IGFET de lecture (Tr).

4. Cellule de mémoire à semi-conducteur selon la revendication 1 ou 2, caractérisé en ce que, soit l'électrode d'écriture planaire (4), soit l'électrode d'effacement planaire (2) forme une zone continue (16, 26) avec la zone de drain (6) de l'IGFET de lecture (Fig. 4).

5. Cellule de mémoire à semi-conducteur selon l'une des revendications 1 à 4, caractérisé en ce que, l'électrode d'écriture planaire (4) avec la zone de drain (6) de l'IGFET de lecture (Tr), et l'électrode d'effacement planaire (2) avec la zone de source (5) de l'IGFET de lecture (Tr), forment chacune des zones continues (Fig. 5).

6. Cellule de mémoire à semi-conducteur selon l'une des revendications 1 à 5, caractérisée en ce que la tension de programmation Up, la concentration en dopage de type N d'au moins une régions partielle de la zone diffusion (4), dont le bord dépasse la portion de surface de l'électrode de grille (Fg) déterminant la capacité de couplage, et l'épaisseur Xox du diélectrique des deux capacités de couplage sont choisies en fonction des expressions suivantes:

$$20\,V \leq Up \leq 35\,V$$

$$\frac{N}{cm^{-3}} \geq 2{,}6 \cdot 10^{17} \cdot \left(\frac{Up}{20\,V}\right)^{-\frac{1}{2}}$$

$$\frac{Xox}{\text{Å}} = 665 \cdot \left(\frac{Up/V}{N/10^{16}\,cm^{-3}}\right)^{\frac{1}{2}} \pm 5\,\%$$

7. Cellule de mémoire à semi-conducteur selon l'une des revendications 1 à 6, caractérisée en ce que la portion de surface de l'électrode de grille (Fg), déterminant la capacité de couplage à l'électrode d'écriture (1), est au moins huit fois plus grande que la portion de surface de l'électrode de grille (Fg) déterminant la capacité de couplage à l'électrode d'effacement.

8. Cellule de mémoire à semi-conducteur selon l'une des revendications 1 à 7, caractérisée en ce que l'électrode de grille (Fg) est realisée en métal.

# FIG.1

# FIG.2

FIG. 3

FIG.4

FIG.5

FIG.6

**FIG.7**

**FIG.8**

# FIG.9